# EUROPÄISCHE PATENTSCHRIFT

(11) **EP 0 264 035 B1**
(45) Veröffentlichungstag und Bekanntmachung des Hinweises auf die Patenterteilung: **16.06.1993**
(21) Anmeldenummer: 87114407.7
(22) Anmeldetag: 02.10.1987
(51) Int. Cl.: H03L 7/08, H04L 7/02

(54) **Phasendiskriminator, insbesondere für eine PLL-Schaltung**
Phase comparator, especially for a phase-locked loop
Discriminateur de phase, en particulier pour boucle d'asservissement de phase

(30) Priorität: 11.10.1986 DE 3634751
(43) Veröffentlichungstag der Anmeldung: 20.04.1988
(73) Patentinhaber: Deutsche Thomson-Brandt GmbH, 78003 Villingen-Schwenningen (DE)
(72) Erfinder: Scholz, Werner, Dipl.-Ing., D-3007 Gehrden (DE)
(74) Vertreter: Einsel, Robert, Dipl.-Ing.

(56) Entgegenhaltungen:
- EP-A- 0 009 939
- US-A- 3 701 039
- IBM TECHNICAL DISCLOSURE BULLETIN, Band 25, Nr. 3B, August 1982, Seiten 1615-1619, New York, US; N.R. DAVIE et al.: "Simplified phase-locked loop"
- IBM TECHNICAL DISCLOSURE BULLETIN, Band 26, Nr. 4, September 1983, Seiten 2148-2149, New York, US; H.R. LEE: "Automatic voltage-controlled oscillator center frequency adjustment"

## Beschreibung

Die Erfindung betrifft einen Phasendiskriminator zur Erzeugung einer von der Phasendifferenz zwischen einer ersten und einer zweiten Impulsfolge abhängigen Ausgangsspannung. Ein derartiger Phasendiskriminator wird z.B. benötigt in der PLL-Schaltung zur Erzeugung des Taktsignals oder des sogenannten Bittaktes aus einer Bitfolge, die ein Digitalsignal, z.B. PCM-Signal im Übertragungscode darstellt.

Am Ausgang einer Übertragungseinrichtung für Digitalsignale (z.B. Digitalaufzeichnungsgerät) besteht fast immer die Aufgabe, das Taktsignal oder den Bittakt der ankommenden Bitfolge wiederzugewinnen. Dies geschieht meist mit Hilfe einer PLL-Schaltung. Die Art des in der PLL-Schaltung verwendeten Phasendiskriminators kann die Eigenschaften der PLL-Schaltung stark beeinflussen. Außerdem ist man bestrebt, innerhalb einer digitalen Signalverarbeitungsschaltung auch die PLL-Schaltung möglichst weitgehend aus digitalen Grundelementen, d.h. Gattern und Flip-Flops, aufzubauen. In der EP-A 0 009 939 wird ein Phasendiskriminator für Digitalsignale angegeben der lediglich aus einem Ex-Or-Gatter besteht.

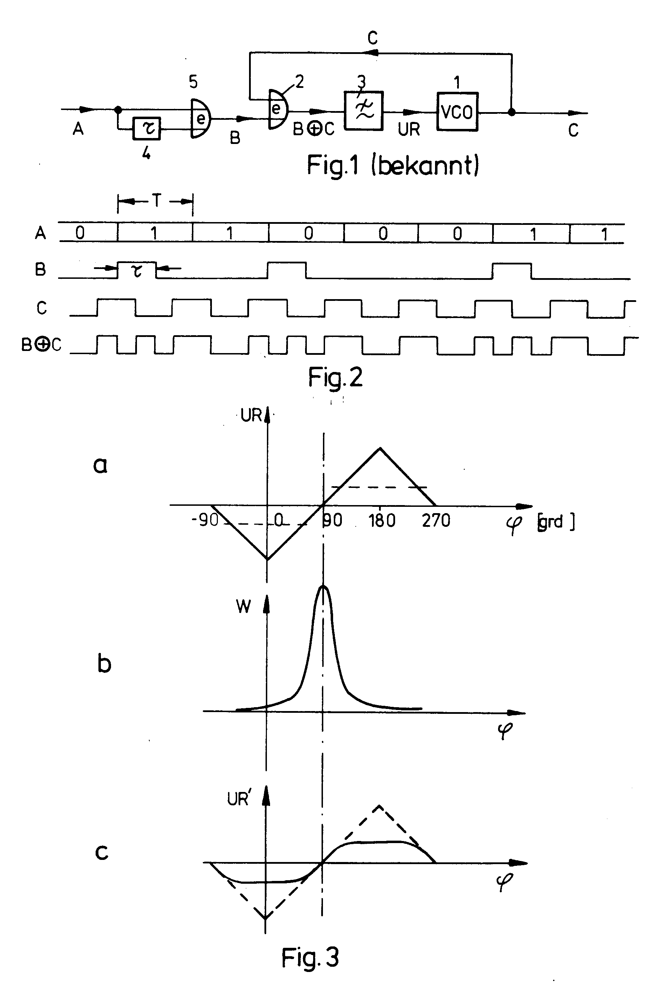

Die genannte bekannte Schaltung, der dabei auftretende Nachteil und die der Erfindung zugrunde liegenden Überlegungen und Erkenntnisse werden im folgenden anhand der Fig. 1 bis 3 erläutert. Dabei zeigt Fig. 3a die Kennlinie eines bekannten Phasendiskriminators und Fig. 3c die modifizierte Kennlinie eines erfindungsgemäß ausgebildeten Phasendiskriminators.

In Fig. 1 ist eine PLL-Schaltung mit dem bekannten Phasendiskriminator dargestellt. Fig. 2 zeigt die zugehörigen Signalverläufe. Aus jedem Pegelübergang der ankommenden Bitfolge A wird mit dem Laufzeitglied 4 mit der Laufzeit τ und dem Ex-Or-Gatter 5 ein Impuls mit der Impulsbreite τ erzeugt, wobei τ möglichst gleich der halben Bitdauer T sein sollte. Die auf diese Weise erzeugte erste Impulsfolge B sowie die in dem Oszillator 1 erzeugte zweite Impulsfolge, die hier gleich dem Bittakt C ist, werden den beiden Eingängen des als Phasendiskriminator dienenden Ex-Or-Gatters 2 zugeführt. Das Ausgangssignal B ⊕ C des Gatters 2 ergibt hinter dem als Schleifenfilter dienenden Tiefpaß 3 die Regelspannung UR für den Oszillator 1. Die Diskriminatorkennlinie, d.h. der Verlauf der Regelspannung UR über der Phase φ zwischen B und C, ist in Fig. 3a dargestellt. Der Arbeitspunkt der PLL-Schaltung wird z.B. durch Ableich des Oszillators 1 auf φ = 90° eingestellt.

Für diese Einstellung ist in Fig. 3b eine Verteilungskurve für die Lage der Pegelübergänge der Bitfolge A angegeben. Die Pegelübergänge konzentrieren sich hier z.B. auf den Bereich 90° +- 30 °. Die Streuung der Pegelübergänge entsteht durch Zeitjitter, also Zeitfehler, eines Wiedergabegerätes, Signalverzerrungen und Rauschen. Soweit der Bittakt C dem Zeitjitter der Bitfolge A folgt, trägt der Zeitjitter nicht zur Verbreiterung der Verteilungskurve Fig. 3b bei. Eine Verbreiterung der Verteilungskurve bedeutet, daß die Wahrscheinlichkeit für das Auftreten von Bitfehlern erhöht wird. Daher soll der Bittakt C dem Zeitjitter so gut wie möglich folgen. Dazu muß die Diskriminatorkurve in ihrem Hauptarbeitsbereich eine bestimmte Mindeststeilheit besitzen. Bei Betrachtung von Fig. 3a und b erkennt man, daß die Diskriminatorkurve auch noch außerhalb ihres Hauptbereiches, der hier bei 90° +- 30° liegt, betragsmäßig weiter ansteigt. Dadurch erhalten selten auftretende Pegelübergänge ein besonders hohes Gewicht für die Erzeugung der Regelspannung, obwohl diese Pegelübergänge wahrscheinlich nicht für die Einstellung der richtigen Taktphase relevant sind. Da die statistisch seltenen Pegelübergänge bei Pegeleinbrüchen gehäuft vorkommen, ist dieser Phasendiskriminator für eine störungsfreie Taktregenerierung nicht optimal geeignet. Bei gehäuft auftretenden Pegelübergängen außerhalb des Hauptstreubereiches kann die Taktphase besonders stark verfälscht werden, und die Wahrscheinlichkeit für das Auftreten von Bit Slips wird erhöht.

Der Erfindung liegt die Aufgabe zugrunde, einen Phasendiskriminator so auszubilden, daß die erzeugte Regelspannung nicht in erhöhtem Maße durch vom Grundwert stark abweichende Phasendifferenzen zwischen der Bitfolge und dem Bittakt verfälscht wird. Dabei soll auch erreicht werden, daß der Phasendiskriminator weitgehend aus digitalen Grundbausteinen herstellbar ist.

Diese Aufgabe wird durch die im Anspruch 1 beschriebene Erfindung gelöst. Vorteilhafte Weiterbildungen der Erfindung sind in den Unteransprüchen beschrieben.

Der Ausdruck Phasendichteverteilung ist ein an sich bekannter Ausdruck. Er bedeutet die Darstellung der Häufigkeit, mit der die jeweilige Phasendifferenz zwischen der Bitfolge und dem daraus erzeugten Bittakt bei einer großen Zahl von Pegelübergängen auftritt, in Form einer Verteilungskurve. Diese Verteilungskurve hat bei einer zeitfehlerfreien Bitfolge einen durch den Oszillator der PLL-Schaltung eingestellten Grundwert, z.B. 90°. Wenn die Bitfolge keine Zeitfehler aufweist und auch sonst keine Störungen vorliegen, hat die Phasendifferenz bei allen Vergleichsvorgängen zwischen der Bitfolge und dem Bittakt diesen gleichen Grundwert. Die Verteilungskurve wäre dann nur ein senkrechter Strich bei dieser Grundphase. Durch unvermeidbare Zeitfehler in der Bitfolge gibt es gegenüber dieser Grundphase Abweichungen, die in Form einer Verteilungskurve darstellbar sind. Durch die Erfindung wird nun erreicht, daß bei Phasendifferenzen, die von dem genannten Grundwert weit abweichen und daher mit hoher Wahrscheinlichkeit kein Maß für die tatsächliche Phasendifferenz darstellen, die Diskriminatorkennlinie einen sehr flachen Verlauf erhält, während die Kennlinie im Bereich der am wenigsten gestörten Pegelübergänge die größte Steilheit besitzt. Bei einem bekannten Phasendiskriminator wird bei einer größeren Phasendifferenz entsprechend einer vorzugsweise linearen Kennlinie auch eine entsprechend große Regelspannung erzeugt. Das ist jedoch im vorliegenden Fall unerwünscht, weil derart starke Phasendifferenzen für das Signal meist nicht repräsentativ sind und eine unerwünschte Änderung der erzeugten Regelspannung bewirken würden, besonders wenn bei bestimmten Signalstörungen, z.B. Dropouts, starke Phasenabweichungen gehäuft auftreten.

Die Erfindung wird im folgenden anhand der Fig. 3c bis 6 erläutert. Darin zeigen
- Fig. 3c: die durch die Erfindung erreichte, modifizierte Kennlinie des Phasendiskriminators,
- Fig. 4: eine Schaltung zur Realisierung der Erfindung,
- Fig. 5: Kurven zur Erläuterung der Wirkungsweise der Schaltung nach Fig. 4 und
- Fig. 6: eine Schaltung gemäß einer Weiterbildung der Erfindung.

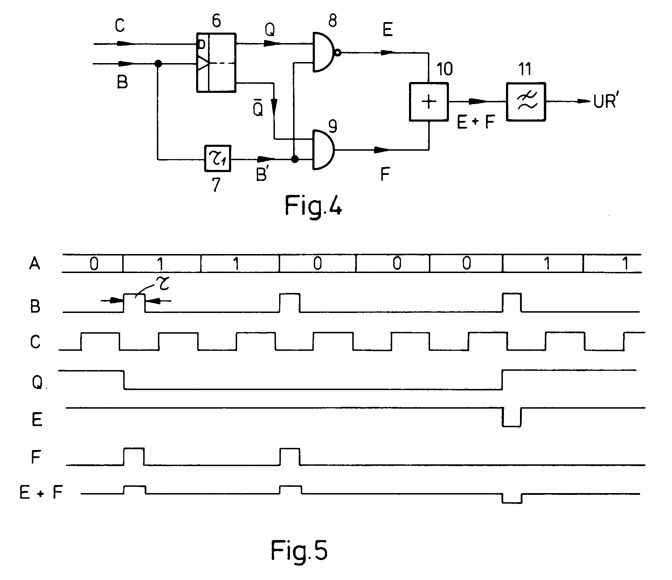

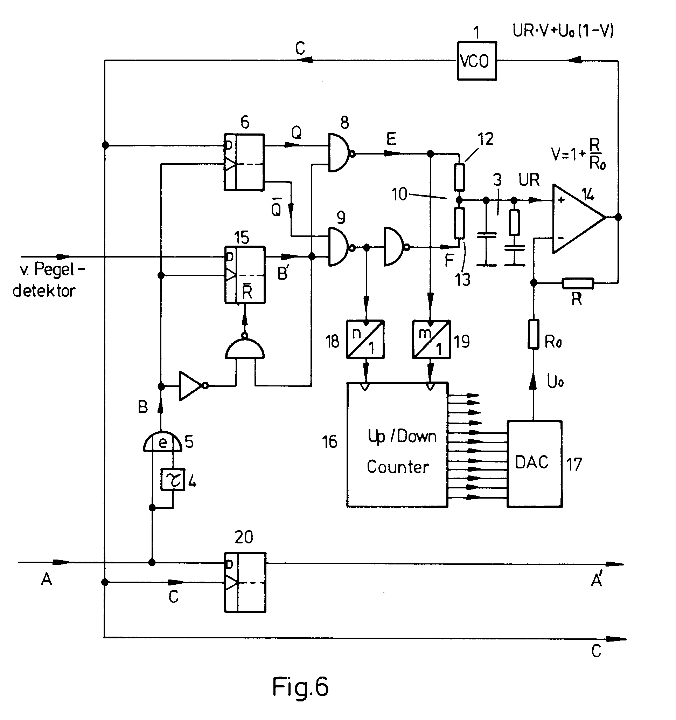

Fig. 3c zeigt eine Diskriminatorkennlinie, deren Steigung der in Fig. 3b dargestellten Phasendichteverteilung entspricht. Diese Diskriminatorkennlinie ist nicht allein durch die Begrenzung einer Diskriminatorkennlinie gemäß Fig. 3a z.B. bis zur gestrichelten Linie herstellbar. Vor allem ist zu bedenken, daß sich die Breite der Verteilungskurve je nach Qualität der Signalübertragung ändern kann. Der versteilerte Bereich der Diskriminatorkurve muß sich dann automatisch der Phasendichteverteilung anpassen. Eine Phasendiskriminatorschaltung, die dies bewerkstelligt, zeigt Fig. 4. In Fig. 5 sind die zugehörigen Signalverläufe dargestellt.

Die aus der modulierten Bitfolge A gewonnene Impulsfolge B stellt wiederum Impulse konstanter Dauer τ dar, die die zeitliche Lage der Pegelübergänge der Bitfolge A markieren. Die Dauer τ braucht nicht gleich der halben Bitdauer T zu sein. Sie sollte lediglich kleiner als der kleinste Pegelübergangsabstand der Bitfolge A sein. Die Impulsdauer τ wirkt sich allerdings auf die Amplitude der Ausgangsspannung UR aus.

Bei dem Phasendiskriminator nach Fig. 4 stellt das D-Flip-Flop 6 fest, ob ein Pegelübergang der Bitfolge A vor oder nach einer abfallenden Flanke des Bittaktes C auftritt. Das Laufzeitglied 7 mit der Laufzeit τ1 dient zum Ausgleich der Laufzeit des D-Flip-Flop 6. Je nach Ausgangs-Spannung Q des D-Flip-Flop 6 erscheint dann am Ausgang des NAND-Gatters 8 ein negativer Impuls E bzw. am Ausgang des AND-Gatters 9 ein positiver Impuls F. Nach Addition der Impulse E und F in der Addierstufe 10 und Tiefpaßfilterung imTiefpaß 11 erhält man die Spannung UR', deren Verlauf die Diskriminatorkennlinie in Fig. 3c darstellt. Die Steilheit dieser Kennlinie entspricht der Phasendichteverteilung der Pegelübergänge der Bitfolge A. Dieser Effekt kommt dadurch zustande, daß jeder Pegelübergang der Bitfolge A betragsmäßig das gleiche Gewicht für die Erzeugung der Spannung UR besitzt. Bei dem Phasendiskriminator in Fig. 1 war dieses Gewicht von der Phasenabweichung des jeweiligen Pegelüberganges abhängig.

Wenn aber jeder Impuls der Impulsfolge B gleiches Gewicht für die Spannungserzeugung besitzt, dann muß die Steigung der Spannungskurve UR bei einer bestimmten Phasenabweichung φ der Häufigkeit der Impulse in der Impulsfolge B mit der betr. Phasenlage entsprechen. Dieser Zusammenhang läßt sich auch auf folgende Weise veranschaulichen: Jeder Wert UR (φ) entspricht dem Integral der gesamten Phasendichteverteilungskurve, wobei der hinter der entscheidenden Flanke des Bittaktes C liegende Teil der Verteilungskurve an der Abszisse gespiegelt ist. Der Nachteil, daß sich Pegelübergänge mit großer Phasenabweichung, die mit hoher Wahrscheinlichkeit für die Erzeugung der Regelspannung in einer PLL nicht relevant sind, mit erhöhtem Gewicht auf die Regelspannungserzeugung auswirken, ist hier beseitigt.

Durch das Zusammensetzen der Impulse E und F in der Addierstufe 10 und dem nachfolgenden integrierenden Tiefpaß 3 entspricht die Ausgangsspannung UR dem Zählerstand eines Zählers, der mit der einen Impulsfolge vorwärts- und mit der anderen Impulsfolge rückwärts zählt. Daher kann der in Fig. 4 dargestellte Phasendiskriminator als Zähl-Phasendiskriminator bezeichnet werden.

Fig. 6 zeigt vorteilhafte Weiterbildungen des beschriebenen Phasendiskriminators innerhalb einer Regenerationsschaltung für eine übertragene Bitfolge A. Die Ausgänge der Schaltung liefern den regenerierten Bittakt C und die mit diesem Bittakt getastete Bitfolge A'. Bei dem in Fig. 6 dargestellten Phasendiskriminator sind gegenüber der in Fig. 4 dargestellten Grundschaltung einige Einzelheiten als Ausführungsbeispiel angegeben. Die durch zwei Widerstände 12, 13 gebildete Addierstufe 10 und der nachfolgende, als Schleifenfilter dienende Tiefpaß 3 sind zu der zwischen den Ausgängen E und F und dem nichtinvertierenden Eingang eines OP-Verstärkers 14 gezeichneten RC-Kombination zusammengefaßt. Mit dem OP-Verstärker 14 ist die Regelverstärkung auf den gewünschten Wert einstellbar. Durch die an die Verstärkerschaltung angelegte Grundspannung Uo wird die Mittenfrequenz der PLL-Schaltung bestimmt.

Der Laufzeitausgleich τ1 durch das Laufzeitglied 7 für das D-Flip-Flop 6 in Fig. 4 wird in Fig. 6 durch ein gleichartiges D-Flip-Flop 15 gebildet, das die B-Impulse überträgt. Die Übertragung kann durch Anlegen der Spannung "0" am D-Eingang des Flip-Flop 15 unterbunden werden. Das kann z.B. bei einem Pegeleinbruch eines von einem Aufzeichnungsgerät abgetasteten Digitalsignals sinnvoll sein, und zwar dann, wenn der Pegel so weit absinkt, daß die Pegelübergänge der Bitfolge A überwiegend verstärktes Rauschen darstellen.

Als weiterer Vorteil des Phasendiskriminators gemäß Fig. 4 bzw. 5 ist anzusehen, daß die Impulse für die vor und hinter der Entscheidungsflanke des Bittaktes C auftretenden Pegelübergänge der Bitfolge A an getrennten Ausgängen E und F verfügbar sind. Das ermöglicht es, auf einfache Weise eine automatische Optimierung der Taktphase für die Abtastung der Bitfolge A durchzuführen. Dadurch ist ein Schaltungsabgleich nicht erforderlich. Die Bitfehlerrate wird automatisch auf einem Minimalwert gehalten, und im Falle einer Abschaltung der synchronisierenden Impulse B während eines Pegeleinbruchs läuft die Phase wegen der ständig optimierten Mittenfrequenz des Oszillators 1 nur minimal weg, so daß die Wahrscheinlichkeit für das Auftreten von Bit Slips vermindert wird.

In Fig. 6 wird die automatische Optimierung der Abtastphase mit Hilfe eines Vor/Rück-Zählers 16 und eines DA-Wandlers 17 durchgeführt. Den beiden Eingängen des Vor/Rück-Zählers 16 werden ggf. über zusätzliche Frequenzteiler 18, 19 die Impulsspannungen E und F zugeführt. Damit eine gute Mittelung beim Vergleich der Impulszahlen von E und F durchgeführt werden kann, sind die Teilerverhältnisse n und m der zusätzlichen Frequenzteiler 18, 19 sowie die Stufenzahl des Vor/Rück-Zählers 16 verhältnismäßig hoch. Die höchstwertigen Ausgänge des Vor/Rück-Zählers 16 werden dem DA-Wandler 17 zugeführt. Die Ausgangsspannung des DA-Wandlers 17 bildet die Grundspannung Uo für die Einstellung der Mittenfrequenz des Oszillators 1. Die Beeinflussung des Oszillators 1 durch die Spannung Uo darf nur in sehr kleinen Stufen erfolgen. Wie die Formeln in Fig. 6 zeigen, ist dies z.B. durch die Wahl eines entsprechend kleinen Widerstandes R zwischen dem Ausgang und dem invertierenden Eingang des Operationsverstärkers 14 durchführbar. Bei richtiger Polung der Spannung Uo stellt sich die PLL-Schaltung dann automatisch so ein, daß die Gleichung E:F = m:n erfüllt wird, wobei hier E und F die Impulszahlen an den betr. Ausgängen darstellen. Normalerweise wird m = n sein. Es kann auch einer der Werte m, n oder beide Werte "1" sein, d.h. der entsprechende Teiler entfällt.

Bei symmetrischer Verteilungskurve Fig. 3b wird der Fall m = n die minimale Bitfehlerrate ergeben. Dieses ist folgendermaßen zu erklären: Bekanntlich läßt sich die Qualität einer übertragenen Bitfolge an Hand des sog. Augendiagramme beurteilen. Das Augendiagramm erhält man durch Darstellung der Bitfolge auf einem mit dem Bittakt C getriggerten Oszillographen. Das Augendiagramm zeigt Häufungen von Pegelübergängen im Abstand der Bitdauer T. Je konzentrieter diese Häufungen sind, d.h. je weniger Pegelübergänge zwischen den Häufungsstellen auftreten, desto fehlerfreier läßt sich die Bitfolge regenerieren, vorausgesetzt die für die Regenerierung erforderliche Abtastung erfolgt in der größten Entfernung von den Häufungsstellen. Durch eine periodische Wiederholung der Verteilungskurve Fig. 3b im Abstand der Bitdauer T läßt sich die Pegelübergangsdichte des Augendiagramms darstellen. Wenn nun in der PLL-Schaltung für die Taktregenerierung eine Automatik dafür sorgt, daß sich die eine Flanke des Bittaktes C stets auf die Mitte der Pegelübergangshäufungen einstellt, dann hat bei symmetrischer Taktspannung die andere Taktflanke die maximale Entfernung von diesen Häufungen. Sofern dann diese Flanke für die regenerierende Signalabtastung verwendet wird, ergibt sich die minimale Bitfehlerrate.

Gemäß Fig. 5 erfolgt die Phasenregelung mit Hilfe der abfallenden Flanke des Bittaktes C. Die Abtastung der übertragenen Bitfolge A erfolgt mit Hilfe eines positiv flankengetriggerten D-Flip-Flop 20, d.h. mit der ansteigenden Flanke des Bittaktes C. Der Abtastaugenblick wird automatisch auf den Zeitpunkt geringster Pegelübergangshäufigkeit gelegt.

In Fig. 6 sorgt die Abschaltmöglichkeit für die Impulse an den Ausgängen E und F bei Pegeleinbrüchen oder in Übertragungspausen dafür, daß während dieser Zeiten die Mittenfrequenz der PLL erhalten bleibt. Damit der Oszillator der PLL auch nach dem Einschalten sofort auf der richtigen Frequenz schwingt, können die Eingangswerte für den DA-Wandler 17 in einem nicht flüchtigen Speicher abgelegt werden. Hierzu dient z.B. ein entsprechendes zusätzliches Register, oder die Stromversorgung der Ausgangs-Flip-Flops des Vor-Rückzählers wird bei ausgeschaltetem Gerät mit Hilfe einer Batterie aufrechterhalten, so daß ihr Zustand bis zum Wiedereinschalten unverändert bleibt.

Die Beschreibung bezieht sich auf binäre Impulsfolgen. Die Erfindung ist aber auch für mehrstufige Übertragungscodes, z.B. ternäre Codes, anwendbar.

## Patentansprüche

1. Phasendiskriminator zur Erzeugung einer von der Phasendiffirenz zwischen einer ersten Impulsfolge (A, B) und einer zweiten Impulsfolge (C) abhängigen Ausgangsspannung, insbesondere für eine PLL-Schaltung zur Erzeugung des Bittaktes aus einem PCM-Signal, **dadurch gekennzeichnet**, daß Mittel vorhanden sind, die bewirken daß jeder Impuls einer ersten Impulsfolge entsprechend seiner Phasenabweichung von einer zweiten Impulsfolge bzw. in Abhängigkeit davon, ob die Bezugsflanke des betreffenden Impulses der ersten Impulsfolge auf die positive oder negative Halbwelle der zweiten Impulsfolge fällt, an einem von zwei Ausgängen einen Impuls konstanter Länge hervorruft und daß die Ausgangsspannung des Phasendiskriminators vom Unterschied der Impulszahlen an den beiden Ausgängen abhängig ist, indem die Ausgangsspannung durch Kombination und Integration der an den beiden Ausgängen stehenden Impulse (E, F) und/oder durch Ermittlung des Impulszahlunterschiedes mit Hilfe von Zählschaltungen (16, 18, 19) und D/A-Wandlung des Zählergebnisses gebildet wird.

2. Diskriminator nach Anspruch 1, dadurch gekennzeichnet, daß die aus der ersten Impulsfolge (A) abgeleitete Impulsfolge (B) aus Impulsen besteht, die die zeitliche Lage der Pegelübergänge einer Bitfolge (A) markieren, und daß die zweite Impulsfolge ein Bittakt (C) mit äquidistanten Pegelübergängen ist, daß jeder Impuls der aus der ersten Impulsfolge (A) abgeleiteten Impulsfolge (B) die Ausgangsspannung (UR) betragsmäßig in gleicher Weise beeinflußt, während die richtungsmäßige Beeinflussung davon abhängig ist, ob die Bezugsflanke des betreffenden Impulses auf eine positive oder negative Halbwelle der zweiten Impulsfolge (C) fällt.

3. Diskriminator nach Anspruch 1 oder 2, dadurch gekennzeichnet, daß die Impulse der aus der ersten Impulsfolge (A) abgeleiteten Impulsfolge (B) abgeschaltet werden, sobald die Wahrscheinlichkeit besteht, daß diese Impulse überwiegend durch Störsignale entstanden sind.

4. Diskriminator nach einem oder mehreren der Ansprüche 1 bis 3, dadurch gekennzeichnet, daß die Impulse der aus der ersten Impulsfolge (A) abgeleiteten Impulsfolge (B) mit einem Vor/Rück-Zähler (16) gezählt werden, wobei die Zählrichtung davon abhängig ist, ob die Impulse auf die positive oder negative Halbwelle der zweiten Impulsfolge (C) fallen, und daß das Zählergebnis mit Hilfe eines DA-Wandlers (17) in eine Spannung (Uo) umgewandelt wird, die als Ergänzung der Ausgangsspannung (VR) dient.

5. Diskriminator nach Anspruch 4, dadurch gekennzeichnet, daß der Vor/Rück-Zähler (16) getrennte Zähleingänge besitzt, und daß diesen Eingängen Frequenzteiler (18, 19) vorgeschaltet sind.

6. Diskriminator nach Anspruch 4 oder 5, dadurch gekennzeichnet, daß das Zählergebnis des Vor/Rück-Zählers (16) in einem nicht flüchtigen Speicher abgelegt ist.

## Claims

1. Phase discriminator for producing an output voltage which is dependent upon the phase difference between a first pulse train (A,B) and a second pulse train (C), particularly for a PLL circuit for producing the bit timing from a PCM signal, characterised in that means are provided which cause each pulse of a first pulse train, according to its phase deviation from a second pulse train or depending upon whether the reference edge of the relevant pulse of the first pulse train falls on the positive or negative half-wave of the second pulse train, to generate a pulse of constant length at one of two outputs, and that the output voltage of the phase discriminator is dependent upon the difference in the pulse counts at the two outputs, the output voltage being formed by combination and integration of the pulses (E, F) at the two outputs and/or by determination of the pulse count difference with the aid of counter circuits (16, 18, 19) and D/A conversion of the counter result.

2. Discriminator as claimed in claim 1, characterised in that the pulse train (B) derived from the first pulse train (A) consists of pulses which mark the time position of the changes of level of a bit string (A), and that the second pulse train is a bit timing pulse (C) with equidistant level changes, that each pulse of the pulse train (B) derived from the first pulse train (A) influences the output voltage (UR) in terms of magnitude in the same way, whilst the influence in terms of direction is dependent upon whether the reference edge of the relevant pulse falls on a positive or negative half-wave of the second pulse train (C).

3. Discriminator as claimed in claim 1 or 2, characterised in that the pulses of the pulse train (B) derived from the first pulse train (A) are switched off as soon as the probability exists that these pulses are produced predominantly by spurious signals.

4. Discriminator as claimed in one or more of claims 1 to 3, characterised in that the pulses of the pulse train (B) derived from the first pulse train (A) are counted with a forwards/backwards counter (16), the direction in which it counts being dependent upon whether the pulses fall on the positive or negative half-wave of the second pulse train (C), and the counter result is converted with the aid of a D/A converter (17) into a voltage (Uo) which serves as a supplement to the output voltage (VR).

5. Discriminator as claimed in claim 4, characterised in that the forwards/backwards counter (16) has separate counter inputs, and frequency dividers (18, 19) are connected upstream of these inputs.

6. Discriminator as claimed in claim 4 or 5, characterised in that the counter result of the forward/backwards counter (16) is stored in a non-volatile store.

## Revendications

1. Discriminateur de phase pour produire une tension de sortie qui dépend de la différence de phase entre une première séquence d'impulsions (A, B) et une seconde séquence d'impulsions (C), en particulier pour un circuit PLL (à verrouillage de phase) pour produire le rythme binaire à partir d'un signal MIC (de modulation par impulsions codées), **caractérisé en ce** qu'il existe des moyens qui provoquent que chaque impulsion d'une première séquence d'impulsions selon son écart de phase par rapport à une seconde séquence d'impulsions ou en fonction du fait si le flanc de référence de l'impulsion concernée de la première séquence d'impulsions tombe sur la demi-onde positive ou négative de la seconde séquence d'impulsions provoque une impulsion de longueur constante à l'une de deux sorties et que la tension de sortie du discriminateur de phase est fonction de la différence des nombres d'impulsions aux deux sorties, la tension de sortie étant formée par combinaison et intégration des impulsions (E, F) qui se trouvent aux deux sorties et/ou par détermination de la différence du nombre d'impulsions à l'aide de circuits de comptage (16, 18, 19) et conversion numérique-analogique du résultat de comptage.

2. Discriminateur selon la revendication 1, **caractérisé en ce** que la séquence d'impulsions (B) dérivée de la première séquence d'impulsions (A) est constituée par des impulsions qui marquent la position temporelle des transitions de niveau d'une séquence de bits (A) et que la seconde séquence d'impulsions est un rythme binaire (C) avec des transitions de niveau équidistantes, que chaque impulsion de la séquence d'impulsions (B) dérivée de la première séquence d'impulsions (A) influence la tension de sortie (UR) en valeur de la même manière tandis que l'influence pour ce qui est du sens dépend du fait de savoir si le flanc de référence de l'impulsion concernée tombe sur une demi-onde positive ou négative de la seconde séquence d'impulsions (C).

3. Discriminateur selon la revendication 1 ou 2, **caractérisé en ce** que les impulsions de la séquence d'impulsions (B) dérivée de la première séquence d'impulsions (A) sont hors circuit dès qu'il est probable que ces impulsions sont engendrées essentiellement par des signaux parasites.

4. Discriminateur selon l'une ou plusieurs des revendications 1 à 3, **caractérisé en ce** que les impulsions de la séquence d'impulsions (B) dérivée de la première séquence d'impulsions (A) sont comptées avec un compteur progressif/régressif (16), le sens de comptage étant dépendant du fait que les impulsions tombent sur la demi-onde positive ou négative de la seconde séquence d'impulsions (C) et que le résultat de comptage est transformé à l'aide d'un convertisseur numérique-analogique (17) en une tension (Uo) qui sert de complément de la tension de sortie (VR).

5. Discriminateur selon la revendication 4, **caractérisé en ce** que le compteur progressi/régressif (16) possède des entrées de comptage séparées et que des diviseurs de fréquence (18, 19) sont placés en amont de ces entrées.

6. Discriminateur selon la revendication 4 ou 5, **caractérisé en ce** que le résultat de comptage du compteur progressif/régressif (16) est déposé dans une mémoire non volatile.
